# EUROPEAN PATENT APPLICATION

(11) **EP 1 903 850 A2**
(43) Date of publication of application: **26.03.2008**
(21) Application number: 07116688.8
(22) Date of filing: 18.09.2007
(51) Int. Cl.: H05K 13/04

(54) **Picker and head assembly with the pickers**

(30) Priority: 22.09.2006 KR 20060092268
(71) Applicant: Mirae Corporation, 330-220 Chungcheongnam-do (KR)
(72) Inventor: Ahn, Jung-ug, 330-220, Chungcheongnam-do (KR); Kim, Sun-hwal, 330-220, Chungcheongnam-do (KR); Choi, Wan-hee, 330-220, Chungcheongnam-do (KR); Hur, Jung, 330-220, Chungcheongnam-do (KR)
(74) Representative: Vetter, Ewald Otto

(57) **Abstract**

Provided is a picker for transferring packaged chips, including a picker base, a base block fixably connected to the picker base, a plurality of nozzle assemblies, provided to the base block, each nozzle assembly being movable up and down, and having a nozzle which a packaged chip is held against or released from by air pressure, an air pressure supplying unit supplying negative or positive pressure by which the packaged chip is held against or released from the nozzle, a plurality of first mechanisms, through each of which the negative or positive pressure is supplied to the nozzle; and a plurality of second mechanisms, each of which moves up and down each of nozzle assemblies.

## Description

### BACKGROUND OF THE INVENTION

### 1. Field of the Invention

The present invention relates to a picker for transferring packaged chips and a head assembly with the pickers for use in a handler.

### 2. Description of the Background Art

At the conclusion of a packaging process, a handler puts packaged chips through a series of environmental, electrical, and reliability tests. These tests vary in type and specifications, depending on the customer and use of the packaged devices. The tests may be performed on all of the packages in a lot or on selected samples.

The handler puts packaged chips into a test tray and supplies the test tray to a tester. The tester includes a test board with a plurality of sockets, performing an electrical test on the packaged chips. The packaged chips are connected to the sockets of the test board for the electrical test. The handler puts the packaged chips into a test tray, i.e. a jig and connecting the packaged chips contained in a test tray to sockets of the test board. The handler sorts the packaged chips according to test results. The handler removes packaged chips from a user tray and put the removed packaged chips into sockets of the test tray. The handler transfers the test tray to the tester. (This is referred as to "a loading operation". The handler removes tested packaged chips from the sockets of the test tray and the tested packaged chips to a user tray (This is referred as to "an unloading operation")

The handler includes a plurality of pickers picking up and transferring the packaged chips in the loading and unloading operations. The picker, movably provided on a body of the handler, picks up, transfers, and places the packaged chips.

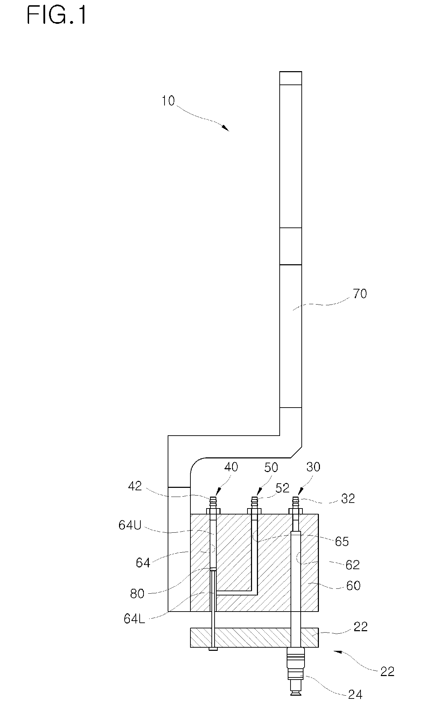

FIG.1 is a view illustrating a conventional picker. As shown in FIG.1, the conventional picker includes a picker base 70, a nozzle assembly 20, an air pressure supplying unit (not shown) supplying negative or positive pressure, a first mechanism 30 through which negative or positive pressure is supplied from the air pressure supplying unit to the nozzle assembly, a second mechanism 40 moving down the nozzle assembly 20, and a third mechanism 50 moving up the nozzle assembly 20.

The nozzle assembly 20 includes a nozzle 24 which is provided on the picker base 70 to be movable up and down. The packaged chips are held against and released from the nozzle 24 by air pressure. Positive or negative pressure is supplied to the nozzle through the first mechanism 30.

A cylinder block 60 is fixably provided to the picker base 70, The nozzle assembly 20 is connected to the cylinder block 60, to be movable up and down. The cylinder block 60 has a first open longitudinal hole 62 inside. A first fitting 32 is provided on a top of the fist open longitudinal hole 62. Air pressure is supplied through the first open longitudinal hole 62 from the fitting 32 to the nozzle 24.

The nozzle assembly 20 further includes a nozzle supporting part 22 to use a method of double acting cylinder, by which the nozzle supporting part 22 is moved up and down. The nozzle supporting part 22 holds the nozzle 24 in place. The nozzle supporting part 22 is connected to the cylinder block 60, to be movable up and down. The cylinder block 60 has a second open longitudinal hole 64 inside. A piston 80 is provided into the second open longitudinal hole 64. The second open longitudinal hole 64 include a upper space 64U and a lower space 64L. The nozzle supporting part 22 is connected the piston 80. A second fitting 42 is provided on a top of the second open longitudinal hole 64.

The cylinder block 60 has a bent longitudinal hole 65 inside, between the first and second open longitudinal holes 62 and 64. One end of the bent longitudinal hole 65 is open and the other is connected to the lower space 64L inside the cylinder block 60. A third fitting 52 is provided on a top of the bent longitudinal hole 65.

The second mechanism 40 moves down the piston 80 by applying positive pressure to an upper space 64U of the second open longitudinal hole 64 through the second fitting 42. Thus, the nozzle supporting part 22 and the nozzle 24, which are coupled to the piston 80, are moved down.

The third mechanism 50 moves up the piston 80 by applying positive pressure to a lower space 64L of the second open longitudinal hole 64 through a third fitting 52. Thus, the nozzle supporting part 22, and the nozzle 24, which are coupled to the piston 80, are moved up.

When connected to a head assembly, the pickers 10, each having one nozzle 24, are arranged in one row. Thus, the nozzles 24 are arranged in one row. However, the packaged chips are placed in two or more rows in a user tray.

As a result, one row of pickers is required to transfer one row of packaged chips at a time. The number of times that the one row of pickers is moved between a unloading stacker and the loading stacker is increased depending upon how many rows of packaged chips are placed in the loading stacker.

This increases the time required to index the pickers from one picking-up position to the next one, thus increasing operating time for the handler.

In the conventional handler, the first, second, and third mechanisms 30, 40, and 50 are all required for each of the nozzles 24.

Furthermore, one cylinder block 60 is required for each of the nozzles 24. The bent longitudinal hole 65 and the second longitudinal hole 64 are required for each of cylinder blocks 60. This increases a size of the cylinder block 60, thereby increasing a size of the picker equipped with the cylinder block 60.

### SUMMARY OF THE INVENTION

Therefore, an object of the present invention is to provide a picker capable of reducing the time required to transfer packaged chips from one position to the next one and a head assembly equipped with the pickers for use in a handler.

Another object of the present invention is to provide a picker having a simplified structure of moving up and down its two or more nozzles, and a head assembly equipped the pickers for use in a handler.

According to an aspect of the present invention, there is provided a picker for transferring packaged chips, including a picker base, a base block fixably connected to the picker base, a plurality of nozzle assemblies, provided to the base block, each nozzle assembly being movable up and down, and having a nozzle which a packaged chip is held against or released from by air pressure, an air pressure supplying unit supplying negative or positive pressure by which the packaged chip is held against or released from the nozzle, a plurality of first mechanisms, through each of which the negative or positive pressure is supplied to the nozzle, and a plurality of second mechanisms, each of which moves up and down each of nozzle assemblies.

According to another aspect of the present invention, there is provided a head assembly for use in a handler, including a head base movable in an X-axis or Y-axis direction along a frame of the handler, a plurality of pickers coupled to the head base, each picker including a picker base, a base block fixably connected to the picker base, a plurality of nozzle assemblies, provided to the base block, each nozzle assembly being movable up and down, and having a nozzle which a packaged chip is held against or released from by air pressure, an air pressure supplying unit supplying negative or positive pressure by which the packaged chip is held against or released from the nozzle, a plurality of first mechanisms, through each of which the negative or positive pressure is supplied to the nozzle; and a plurality of second mechanisms, each of which moves up and down each of nozzle assemblies; and a picker base moving unit moving up and down the plurality of second mechanisms.

According to the present invention, the time required to index the pickers from one picking-up position to the next one is reduced, thus reducing operating time for the handler.

The foregoing and other objects, features, aspects and advantages of the present invention will become more apparent from the following detailed description of the present invention when taken in conjunction with the accompanying drawings.

### BRIEF DESCRIPTION OF THE DRAWINGS

The accompanying drawings, which are included to provide a further understanding of the invention and are incorporated in and constitute a part of this specification, illustrate embodiments of the invention and together with the description serve to explain the principles of the invention.

In the drawings:
FIG. 1 is a view illustrating a conventional picker;
FIG.2 is an exploded view illustrating a picker 100 according to an embodiment of the present invention;
FIG.3 is a perspective view illustrating the picker 100 of FIG.2;
FIG.4 is a cross-sectional view illustrating that a nozzle-holding member is positioned at a first position in the picker 100 of FIG.2;
FIG.5 is a cross-sectional view illustrating that a nozzle-holding member is positioned at a second position in the picker 100 of FIG.2;
FIG.6 is a perspective view illustrating a head assembly for use in a handler, equipped with the picker of FIG.2;
FIG.7 is a plane view schematically illustrating the handler equipped with the head assemblies of FIG.6; and
FIGs 8 through 11 are views illustrating that the head assembly equipped with the pickers according to the embodiment of the present invention picks up and transfers packaged chips.

### DETAILED DESCRIPTION OF EXEMPLARY EMBODIMENTS

Reference will now be made in detail to the preferred embodiments of the present invention, examples of which are illustrated in the accompanying drawings.

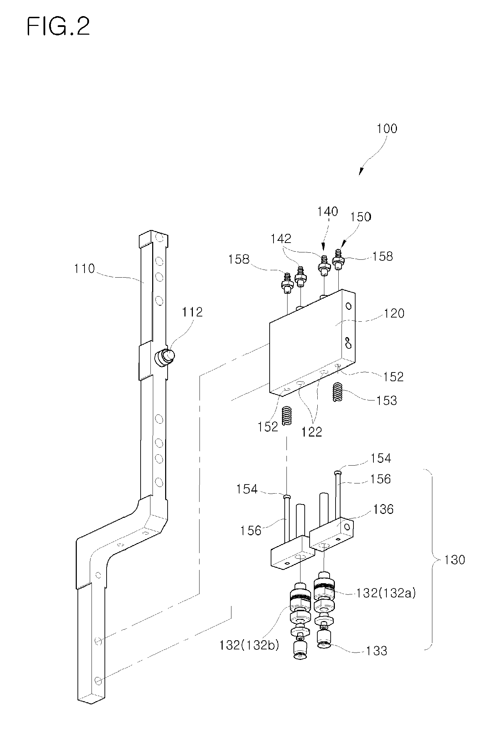

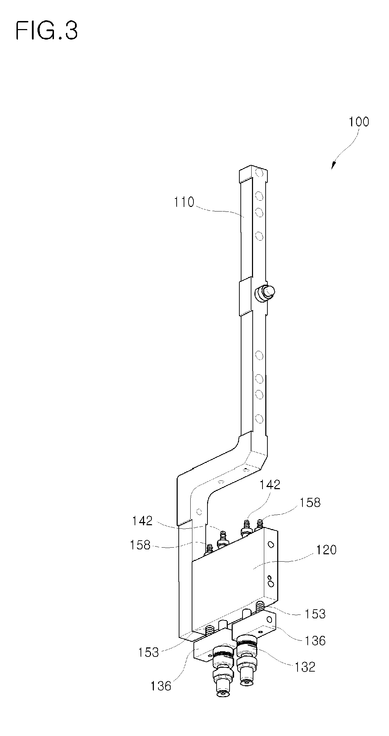

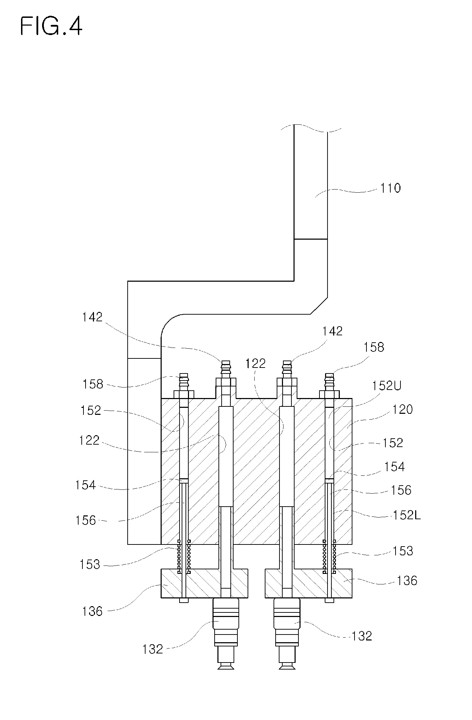

FIG.2 is an exploded view illustrating a picker 100 according to an embodiment of the present invention. FIG.3 is a perspective view illustrating the picker 100. FIG.4 is a cross-sectional view illustrating the picker 100. As shown in FIGs 2 through 4, the picker 100 according to the embodiment of the present invention, includes a picker base 110, a base block 120, nozzle assemblies 130, an air pressure supplying unit (not shown) supplying negative or positive pressure, a plurality of first mechanisms 140, through each of which the negative or positive pressure is supplied to the nozzle; and a plurality of second mechanisms 150, each of which moves up and down each of nozzle assemblies.

The picker 100 picks up and places the packaged chips from a loading stacker 310 and to an unloading stacker. Two or more pickers 100 are provided in a row to a main frame, to be movable along the main frame. The main frame and the pickers 100 are parts of a head assembly which is horizontally movable.

The base block 120 is fixably provided to the picker base 110. The picker base 110 and the base block 120 may be formed as one body.

A nozzle assembly 130 is connected to the base block 120, to be movable up and down. The nozzle assembly 130 includes a nozzle 132. The nozzle 132 has a tip 133 on its end. When negative pressure is applied, the packaged chip is held against the tip 133. When positive pressure is applied, the packaged chip is released from the tip 133.

Two or more nozzle assemblies are connected to one base block 120, each having one nozzle.

Positive or negative pressure is supplied through the first mechanism 140, to hold or release the packaged chips against or from the tip 133. The first mechanism is connected to an air pressure supplying unit (not shown). The air pressure supplying unit may be provided to the picker 100 or the main frame. A first longitudinal hole 122, which is open, is formed inside the base block 120. A first fitting 142, which connects between the first mechanism 140 and the first longitudinal hole 122, is provided to the base block 120.

A second mechanism 150 moves up and down the nozzle assembly 130.

The picker 100 includes two or more nozzles 132. Two or more pickers are provided, in a row, to the head assembly. This makes the nozzles be arranged in two or more rows. One row of nozzles 132a descends to pick up one row of packaged chips on the loading stacker, and then another row of nozzles 132b descend to pick up another row of packaged chips on the loading stacker. This process is repeatedly performed until all pickers pick up the packaged chips. When all pickers pick up the packaged chips, the head assembly is moved to the unloading stacker. The head assembly with the pickers according to the embodiment of the present invention carries more packaged chips than a conventional head assembly with the pickers each of which has one row of nozzles. All pickers may descend to pick up corresponding packaged chips, at the same time.

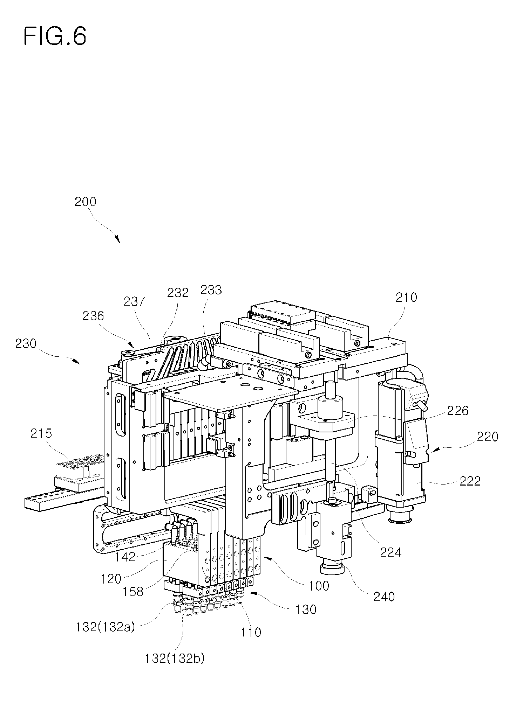

As shown in FIG.6, when the pickers, each having two nozzles, are provided to the head assembly, nozzles are arranged in two rows. Each picker may include three or more nozzles, thus making the nozzles arranged in three or rows.

As shown in FIG.2, one picker includes two nozzle assemblies 130, each of which is connected to each of two second mechanisms 150. The two second mechanisms 150 may operate individually, thus moving up and down two nozzle assemblies 130 individually. As a result, the nozzles are moved up and down individually, or at the same time to pick up the packaged chips.

The nozzle assembly 130 includes a nozzle-holding member 136. The nozzle-holding member 136 serves to connect the nozzle 132 to the base block 120. The nozzle-holding member 136 is connected to the base block 120, to be movable up and down. As a result, the nozzle 132 is moved up and down as the nozzle-holding member 136 is moved up and down. The second mechanism 150 moves up and down the nozzle holding member 136 by applying negative pressure and positive pressure to the second longitudinal hole 152.

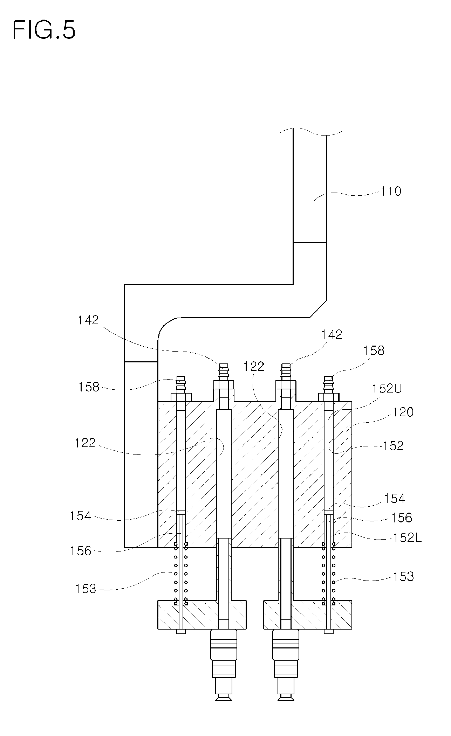

Referring to FIGs 4 and 5, how to move up and down the nozzle-holding member 136 is now described as an example. A second longitudinal hole 152 and a piston 154, and a connecting rod 156 cooperate with each other to move up and down the nozzle-holding member 136. The second longitudinal hole 152 is formed inside the base block 120. A second fitting 158 connects between the second longitudinal hole 152 and the air pressure supplying unit (not shown). The air pressure supplying unit may be provided to the picker or the main frame.

The piston 154 slides up and down inside of the second longitudinal hole 152. The piston 154 divides a space in the second longitudinal hole 152 into two spaces, an upper space and a lower space.

The connecting rod 156 connects between the nozzle-holding member 136 and the piston 154. The nozzle-holding member 136 is moved up and down as the piston 154 slides up and down by air pressure.

Positive pressure needs to be applied into the lower space 152L of the second longitudinal hole 152 to move up the nozzle-holding member 136. However, this requires formation of another longitudinal inside of the base block 120, which is to be connected to the upper space 152 L of the second longitudinal hole 152. Accordingly, the base block 120 has to be larger in size and more complex in structure.

According to the embodiment of the present invention, an elastic member 153, such as a coil spring, is provided to the nozzle-holding member 136. That is, one end of the elastic member 153 is fixed to a bottom of the base block 120 and the other to a upper region of the nozzle-holding member 136, with the piston 154 and the connecting rod 1'56 inside of the elastic member 153. The nozzle member 153 remains moved up without air pressure being applied to the upper space of the second longitudinal hole 152.

As shown in FIG.4, elastic force of the coil spring is set to "0" when the nozzle-holding member 136 remains moved up to a first position. As shown in FIG.6, when the nozzle-holding member 136 is moved down to a second position, elastic force of the coil spring increases in proportion to a distance between the first and second positions. Thus, when applied air pressure is smaller than elastic force of the coil spring at work, the nozzle-holding member 136 begins to be moved up by virtue of elastic force of the coil spring at work.

Use of the elastic member 153 does not necessitate formation of additional longitudinal hole inside of the base block 120. Absence of an additional longitudinal hole provides room for additional nozzle-holding member, thus enabling the picker to be equipped with two nozzles.

FIG.6 is a perspective view illustrating the head assembly 200 for use in a handler, equipped with the picker 100. As shown in FIG.6, the head assembly 200 for use in the handler, includes the picker 100, a head base 210, a picker base moving unit 220 moving the picker base 110.

The head base is provided on an X-axis and Y-axis frame (not shown) in a manner that moves the head assembly in an X-axis or Y-axis direction. A plurality of pickers 100 is provided to the head base 210.

Each of the pickers 100 includes two or more nozzles which are spaced apart at regular intervals. Thus, when the pickers 100 are combined, the nozzles on the pickers 100 are arranged in two or more rows. The picker 100 includes a picker base 110, a base block 120, and two or more nozzle assemblies 130, which are the same as those shown in FIGs 2 through 5. Therefore, their descriptions are omitted.

The nozzle is moved up and down by air pressure supplied by the second mechanism 150, as shown in FIGs 4 and 5. Positive pressure or negative pressure is supplied to hold or release the packaged chip against or from the nozzle.

The picker 100 is moved up and down by the picker base moving unit 220. The picker base moving unit 220 includes a Z-axis motor 222, a rotating shaft 224 and a picker base holding member 226. An outside surface of the rotating shaft 224 is threaded. The rotating shaft 224 is provided in a Z-axis direction. The rotating shaft 224 is rotated by the Z-axis motor 222. The picker base holding member 226 is connected to the threaded outside surface of the rotating shaft 224, with balls in between. As a result, rotary motion of the rotating shaft 224 is transformed into linear vertical motion of the picker base holding member 226. This enables the picker base 110, which is connected to the picker base holding member 226, to be moved up and down.

The rotating shaft 224 may be directly connected to the Z-axis motor 222. The rotating shaft 224 may be connected to the Z-axis motor 222, with a drive pulley, a driven pulley, and a belt connecting between the drive pulley and the driven pulley.

All pickers 100 are moved down a certain distance by picker base moving unit 220. From there, all pickers are individually further moved down to pick up the packaged chips. This two-steps movement of the pickers 100 enables the pickers 100 to accurately pick up the packaged chips of small size and to shorten the pick-up time.

There are various sizes of packaged chips. Accordingly, the head assembly 200 may further include a distance adjusting unit 230, which adjusts a distance between the pickers, depending upon a distance between the packaged chips. The space adjusting unit 230 includes a cam plate 232 and a cam plate moving device 236 moving up and down the cam plate 232. Guide holes 233, which guides movement of the picker base 110, are formed on the cam plate 232, like ribs of a fan.

A distance between the guide holes 233 becomes larger or smaller as the guide holes 233 go up from the bottom of the cam plate 232 toward the top of the cam plate 232. A picker base connecting part 112 (as shown in FIG.2) is inserted into the guide hole 233. Thus, the distance between the pickers becomes larger or smaller as the cam plate 232 is moved up or down.

In a case where the distance between the guide holes 233 becomes smaller as the guide holes 233 go up from the bottom of the cam plate 232 toward the top of the cam plate 232, elevation of the cam plate 232 makes the picker base connection part 112 (as shown in FIG.2) move along the guide hole 233, thus allowing the distance between the pickers to become larger. A cam plate moving unit (not shown), which moves up and down the cam plate, may include the cam motor and a power transmission shaft 237 connecting between the cam motor and the cam plate.

The head assembly 200 may further include a camera 240 which serves to collect visual data on the positions of the packaged chips, necessary for the picker to accurately pick up the packaged chips.

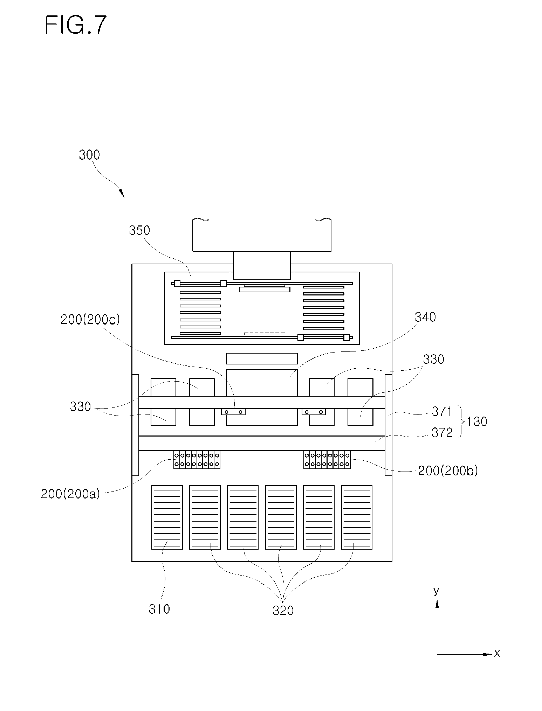

FIG.7 is a plane view schematically illustrating the handler 300 equipped with the head assemblies of FIG.6 according to the embodiment of the present invention.

As shown in FIG.7, the handler 300, which handles the packaged chips for test, includes a loading stacker 310, an unloading stacker 320, a buffer unit 330, an exchanging unit 340, a testing unit 350, and a plurality of head assemblies 200.

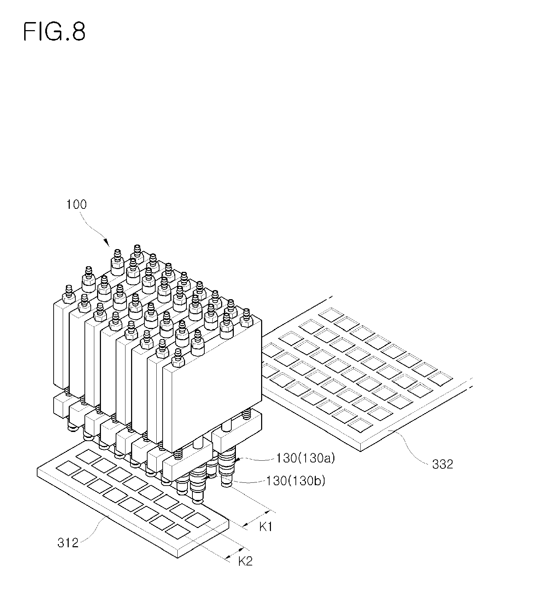

The loading stacker 310 is provided in the front. User trays 312 (as shown in FIG.8), each of which contains to-be-tested packaged chips, are placed on the loading stacker 310.

The unloading stacker 320 is provided adjacent to the loading stacker 310. Tested packaged chips, after sorted according to grades, are contained in their assigned user trays on the unloading stacker 320.

The buffer unit 330 is provided between the loading stacker 310 or the unloading stacker 320 and the exchanging unit 340. The buffer unit 330 temporarily receives the packaged chips transferred by the head assembly. The buffer unit 330 includes a plate. The buffer units 330 may be provided next to both sides of the exchanging unit 340 which is provided in the middle of the main body of the handler. That is, the buffer unit 330 may include a loading buffer unit and an unloading buffer unit. In this case, the exchanging unit 340 is provided between the loading and unloading buffer units. The buffer unit 330 may include two or more plates movable in an Y-axis direction.

The exchanging unit 340 is an area where the to-be-tested packaged chips are loaded into a test tray, or the tested packaged chips are unloaded from the test tray. After the unloading picker picks up and places the tested packaged chips from the test tray and on the unloading buffer in the exchanging unit 340, the loading picker picks up and inserts the to-be-tested packaged chips from the loading buffer and into the empty test tray,

A first head assembly 200A and a second head assembly 200B, which are moved linearly in an X-axis, or Y-axis direction, are provided between the loading stacker 310 and the buffer 330, and between the unloading stacker 320 and the buffer 330, respectively. The first head assembly 200A is moved between the loading stacker 310 and the loading buffer of the buffer unit 330, to transfer the packaged chips. The second head assembly 200B is moved between the unloading buffer of the buffer unit 330 and the unloading stacker 320, to transfer the packaged chips.

A third head assembly 200C is provided which is moved between the exchanging unit 340 and the buffer unit 330. That is, the third head assembly 200C, which is moved linearly in an X-axis direction, transfers the packaged chips from the buffer unit 330 to the exchanging unit 340, or from the exchanging unit 340 to the buffer unit 330.

The first and second head assemblies 200A and 200B are movable along X axis and Y-axis gantries 370, in the X-axis or Y-axis direction. That is, the first and second head assemblies 200A and 200B are supported by an X-axis gantry 372, in a manner that enables slidable motion of the first and second assemblies 200A and 200B in the X-axis direction. The X-axis gantry 372 is supported by an Y-axis gantry 371, in a manner that enables slidable motion of the X-axis gantry 372 in the Y-axis direction. At least one of the first, second, and third head assemblies 200A, 200B, and 200C is equipped with two or more pickers, each having two or more nozzles, in a manner which arranges the nozzles in two or more rows and in two or more columns.

A heating-up chamber, a test chamber, and a cooling-down chamber are provided behind the handler 300. A test board, which tests the packaged chips for electrical characteristic under specific temperature, is provided opposite to the test chamber.

FIGs 8 through 11 are perspective views illustrating steps that the first head assembly 200A picks up and transfers the packaged chips from the loading stacker 310 and to the buffer unit 330. Referring to FIGs 8 through 11, operation of the head assembly 200 according to the embodiment of the present invention is now described. Two or more pickers 100, each having two nozzle assemblies 130, are arranged in a row in the first head assembly 200A.

As shown in FIG.8, a user tray 312 is placed on the loading stacker 310. The first head assembly 200A is moved over the user tray 312 on the loading stacker 310.

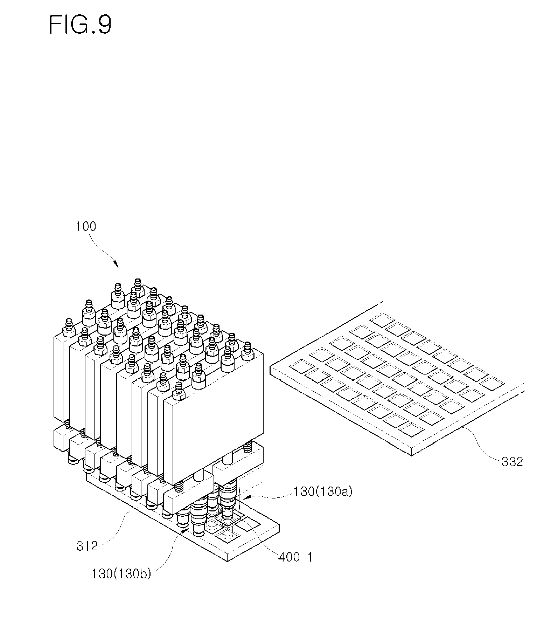

Thereafter, a first row of nozzles 130A of the first head assembly 200, as shown in FIG.9, is moved down to pick up a first row 400-1 of packaged chips on the user tray 312.

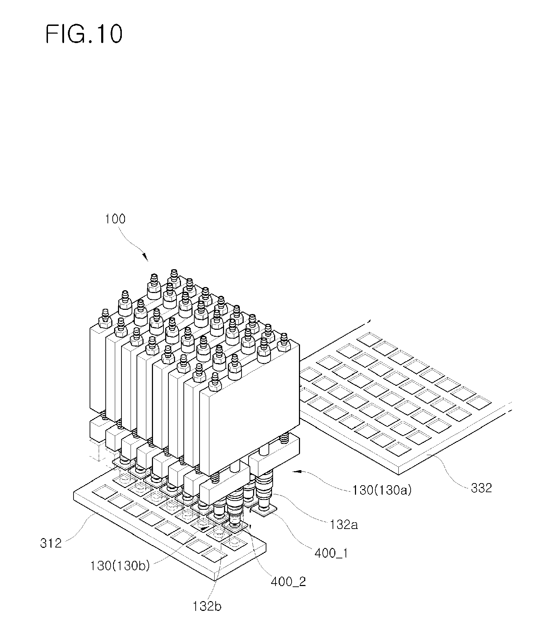

Thereafter, a second row of nozzles 130B of the first head assembly 200, as shown in FIG.10, is moved down to pick up a second row 400-2 of packaged chips on the user tray 312.

Descent of the first row of nozzles may be followed by descent of the second row of nozzles. The first and second rows of nozzles may be moved down at the same time to pick up two rows of packaged chips in the user tray 312. To do so, a space K1 between two adjacent nozzles in the first and second rows, as shown in FIG.9, is either the same as, or a whole number times a space K2 between two adjacent packaged chips in a row.

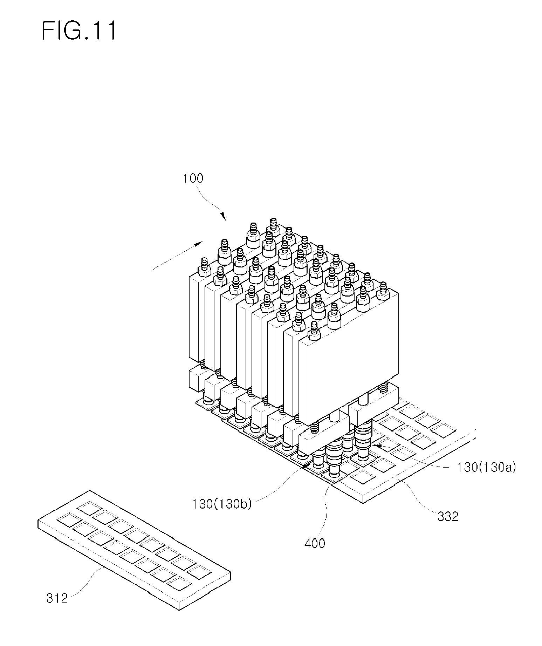

Thereafter, the first head assembly 200, as shown in FIG.11, is moved over the buffer unit 330 to places the picked-up packaged chips on a buffer plate 332 on the buffer unit 330.

The conventional first head assembly 200A picks up packaged chips which are arranged in a row in the user tray 312 on the loading stacker 310 and places the picked-up packaged chips on the buffer plate. The conventional first head assembly 200A repeats this operation until all packaged chips in the user tray 312 on the loading stacker 310 are transferred to the buffer plate 330. This increases the cost of operating time. However, use of the first head assembly 200A according to the embodiment of the present invention decreases the cost of operating time.

The second head assembly 200B or the third head assembly 200C, as well as the first head assembly 200A, may be equipped with two or more pickers, each having two or more nozzles, in a manner which arranges the nozzles in two or more rows and in two or more columns. This further decreases the cost of operating time.

Use of the elastic member enables the picker be equipped with two or more the nozzles, without having to form additional longitudinal hole inside of the base block, necessary to move up the nozzle assembly.

As the present invention may be embodied in several forms without departing from the spirit or essential characteristics thereof, it should also be understood that the above-described embodiments are not limited by any of the details of the foregoing description, unless otherwise specified, but rather should be construed broadly within its spirit and scope as defined in the appended claims, and therefore all changes and modifications that fall within the metes and bounds of the claims, or equivalents of such metes and bounds are therefore intended to be embraced by the appended claims.

## Claims

1. A picker for transferring packaged chips, comprising:
a picker base;
a base block fixably connected to the picker base;
a plurality of nozzle assemblies, provided to the base block, each nozzle assembly being movable up and down, and having a nozzle which a packaged chip is held against or released from by air pressure;
an air pressure supplying unit supplying negative or positive pressure by which the packaged chip is held against or released from the nozzle;
a plurality of first mechanisms, through each of which the negative or positive pressure is supplied to the nozzle; and
a plurality of second mechanisms, each of which moves up and down each of nozzle assemblies.

2. The picker for transferring packaged chips, according to claim 1, wherein the second mechanisms are individually moved up and down.

3. The picker for transferring packaged chips, according to claim 2, wherein the second mechanisms are moved up and down at the same time.

4. The picker for transferring packaged chips, according to claim 2, wherein the nozzle assemble further comprises a nozzle-holding member which is fixably connected to the nozzle and which is connected to the second mechanism.

5. The picker for transferring packaged chips, according to claim 4, wherein the second mechanism comprises:
a piston sliding up and down in a cylindrical hole pierced through the second mechanism, the cylindrical hole connected to the air pressure supplying unit; and
a connecting rod whose one end is connected to the nozzle holding member and whose the other end is connected to the piston; and
an elastic member moving up the nozzle assembly by a restoring force

6. The picker for transferring packaged chips, according to claim 5, wherein the connecting rod is pierced through the elastic member.

7. The picker for transferring packaged chips, according to claim 6, wherein the elastic member comprises a coil spring whose one end is connected to the base block and whose the other end is connected the nozzle holding member.

8. A head assembly for use in a handler, comprising:
a head base movable in an X-axis or Y-axis direction along a frame of the handler;
a plurality of pickers coupled to the head base, each picker comprising:
a picker base;
a base block fixably connected to the picker base;
a plurality of nozzle assemblies, provided to the base block, each nozzle assembly being movable up and down, and having a nozzle which a packaged chip is held against or released from by air pressure;
an air pressure supplying unit supplying negative or positive pressure by which the packaged chip is held against or released from the nozzle;
a plurality of first mechanisms, through each of which the negative or positive pressure is supplied to the nozzle; and
a plurality of second mechanisms, each of which moves up and down each of nozzle assemblies; and
a picker base moving unit moving up and down the plurality of second mechanisms

9. The head assembly for use in a handler according to claim 8, wherein the second mechanisms are individually moved up and down.

10. The head assembly for use in a handler according to claim 9, wherein the second mechanisms are moved up and down at the same time.

11. The head assembly for use in a handler according to claim 9, wherein the nozzle assemble further comprises a nozzle-holding member which is fixably connected to the nozzle and which is connected to the second mechanism.

12. The head assembly for use in a handler according to claim 11, wherein the second mechanism comprises:
a piston sliding up and down in a cylindrical hole pierced through the second mechanism, the cylindrical hole connected to the air pressure supplying unit; and
a connecting rod whose one end is connected to the nozzle holding member and whose the other end is connected to the piston; and
an elastic member moving up the nozzle assembly by a restoring force

13. The head assembly for use in a handler according to claim 12, wherein the elastic member comprises a coil spring whose one end is connected to the base block and whose the other end is connected the nozzle holding member.

14. The head assembly for use in a handler according to claim 8, wherein the picker base moving unit comprises:
a Z-axis motor;
a picker base holding member to which the picker bases are coupled; and
a rotating shaft, whose an outside surface is threaded, rotary motion of the rotating shaft by the Z-axis motor being transformed into linear vertical motion of the picker base holding member.

15. The head assembly for use in a handler according to claim 8, further comprising a distance adjusting unit, which comprises:
a cam plate on which guide holes are formed, like ribs of a fan, to guide movement of the picker base; and
a cam plate moving device moving up and down the cam plate.
